(19) Europäisches Patentamt
European Patent Office
Office européen des brevets

(11) Veröffentlichungsnummer: **0 251 040 B1**

(12) **EUROPÄISCHE PATENTSCHRIFT**

(45) Veröffentlichungstag der Patentschrift: **21.11.91**

(51) Int. Cl.⁵: **G01R 1/067, H01R 13/15**

(21) Anmeldenummer: **87108739.1**

(22) Anmeldetag: **18.06.87**

(54) **Federkontaktstift und Verfahren zu seiner Herstellung.**

(30) Priorität: **23.06.86 DE 3620946**
**29.12.86 DE 3644643**

(43) Veröffentlichungstag der Anmeldung:
**07.01.88 Patentblatt 88/01**

(45) Bekanntmachung des Hinweises auf die
Patenterteilung:
**21.11.91 Patentblatt 91/47**

(84) Benannte Vertragsstaaten:
**AT BE CH DE FR GB IT LI NL SE**

(56) Entgegenhaltungen:
**DE-A- 2 643 606**

**JAHRBUCH DER DEUTSCHEN GESELL-
SCHAFT FÜR CHRONOMETRIE, Band 30,
1979, Seiten 269-276, DE; G. KRÜGER:
"Prüfmittel zur elektrischen Prüfung von Leiterplatten für Uhren"**

(73) Patentinhaber: **Feinmetall Gesellschaft mit beschränkter Haftung
Zeppelinstrasse 2
W-7033 Herrenberg(DE)**

(72) Erfinder: **Giringer, Klaus
Ehbühl 14
W-7033 Herrenberg(DE)**
Erfinder: **Hinnerwisch, Sven, Dipl-Phys.
Akazienweg 7
W-7031 Nufringen(DE)**
Erfinder: **Krüger, Gustav, Dr.
Danziger Strasse 1
W-7033 Herrenberg(DE)**

(74) Vertreter: **Grosse, Rainer, Dipl.-Ing. et al
Gleiss & Grosse Patentanwaltskanzlei Silberburgstrasse 187
W-7000 Stuttgart 1(DE)**

## Beschreibung

Die Erfindung betrifft einen Federkontaktstift gemäß dem Oberbegriff des Anspruches 1 und ein Verfahren zu seiner Herstellung.

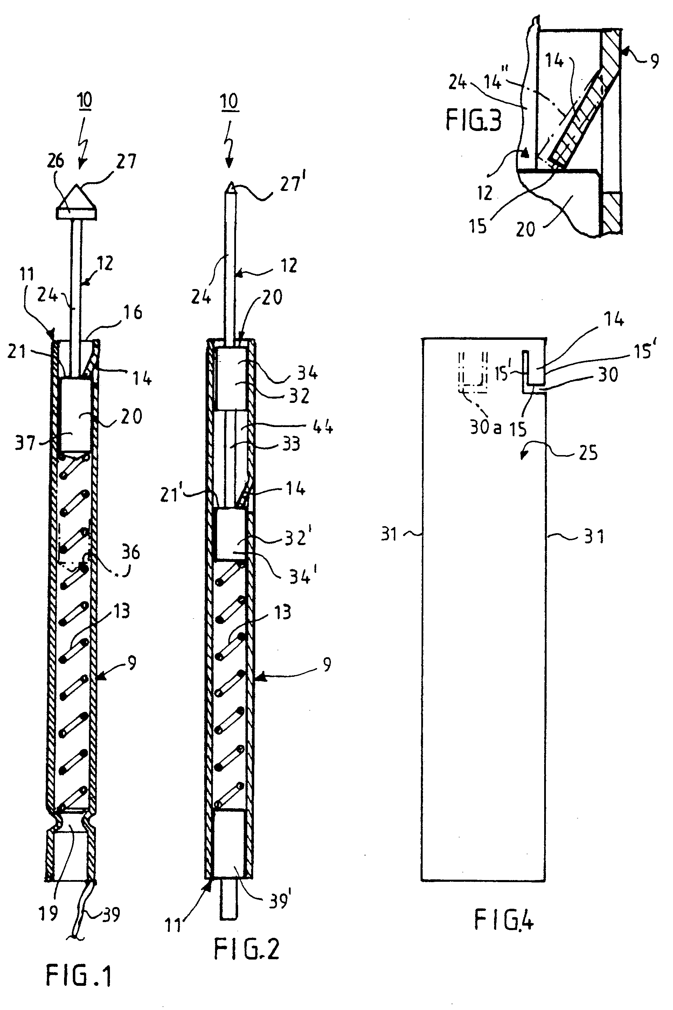

Prüfvorrichtungen dieser Art sind bekannt und weisen im allgemeinen einen Prüfadapter oder dgl. mit einer Vielzahl von dem Kontaktieren von zu prüfenden Leiterplatten oder sonstigen Prüflingen dienenden Federkontaktstiften auf, siehe z. B. Krüger, "Prüfmittel zur Prüfung von Leiterplatten für Uhren", Jahrbuch der Deutschen Gesellschaft für Chronometrie, Bd. 30, 1979, S. 269-276. Insbesondere auf S. 272, Abb. 3 ist der Aufbau solcher Federkontaktstifte dargestellt, die entweder direkt in Bohrungen des Prüfadapters oder in Überhülsen, die sich in den Bohrungen des Prüfadapters befinden, eingesteckt sind. Der Zusammenbau solcher bekannter Federkontaktstifte fand bisher auf die Weise statt, daß in das Zylinderglied (Rohr) die Feder und das Kontaktglied eingeschoben und dann an der Umfangswandung des Zylindergliedes ein Anschlag für die vordere Ruhestellung des Kontaktgliedes angeformt wird, an welchen eine Druckfeder den Kolben des Kontaktgliedes andrücken kann. Dieser Anschlag ist durch einwärtiges Umbördeln des oberen Endes des Zylindergliedes oder Eindrücken eines Innenringbundes in das Zylinderglied gebildet. Derartige Verformungen des Zylindergliedes als Anschlag für den Kolben sind jedoch schon im Hinblick auf die äußerst geringen Durchmesser der Zylinderglieder von im allgemeinen maximal 2,5 mm, meist jedoch erheblich weniger, schwierig, und diese nachträgliche Verformung des Zylindergliedes birgt die Gefahr von Beschädigungen des Zylindergliedes an der Kolbenlaufbahn, die bis zum Ausschuß des betreffenden Zylindergliedes führen können, oder des Einklemmens des Kolbens des Kontaktgliedes in sich.

Es ist deshalb eine Aufgabe der Erfindung, einen Federkontaktstift der eingangs genannten Art zu schaffen, dessen Zusammenbau rasch und kostengünstig durchgeführt werden kann und nicht mehr die Gefahr von Beschädigungen des Zylindergliedes an der Kolbenlaufbahn bzw. des Einklemmens des Kolbens des Kontaktgliedes hervorruft.

Diese Aufgabe wird hinsichtlich des Federkontaktstiftes erfindungsgemäß durch einen Federkontaktstift gemäß Anspruch 1 und hinsichtlich des Verfahrens zur Herstellung eines solchen Federkontaktstiftes durch ein Verfahren gemäß Anspruch 17 gelöst.

Aus der DE-A-2643606 ist ein mehrpoliger elektrischer Stecker bekannt, in dem eine Federhülse verwendet ist, bei der Lappen aus einem Bereich der Umfangswandung dieser Hülse gebildet sind und in den Hülseninnenraum hineinragen.

Diese als Schnappverbindung wirkenden Lappen dienen dazu, den Steckkontakt in seiner Endstellung zu verriegeln.

Das Rohr mit dem mindestens einen Lappen ist baulich einfach und auch bei sehr kleinen Durchmessern kostengünstig herstellbar. Auch ist der Zusammenbau des erfindungsgemäßen Federkontaktstiftes äußerst einfach. Es ist lediglich erforderlich, nacheinander die Federmittel und den Kolben des Kontaktgliedes in das Zylinderglied einzuschieben und gegebenenfalls dann den oder die Lappen in das Rohrinnere zu biegen. Es besteht nicht mehr die Gefahr von Beschädigungen des Rohres an der Kolbenlaufbahn, da das Biegen des oder der Lappen problemlos möglich ist. Auch besteht keine Gefahr des Einklemmens des Kolbens mehr, da er zur Anlage an den mindestens einen Lappen kommt, vorzugsweise an eine Kante des Lappens. Obwohl es bereits vorteilhaft ist, wenn oder die Lappen erst nach Einsetzen des Kolbens in das Zylinderglied gebogen werden und dann vorzugsweise unelastisch sein kann bzw. können, kann dieser Arbeitsgang dadurch entfallen und der Zusammenbau des Federkontaktstiftes so noch rascher erfolgen, indem vorgesehen ist, daß der mindestens eine Lappen einen elastisch federnden, vorzugsweise zungenförmigen Widerhaken bildet, der so angeordnet ist, daß er das Einsetzen des Kolbens in das Rohr unter durch den Kolben dabei bewirktem federndem Ausbiegen zuläßt.

Bei dem Einschieben gleitet der Kolben oder ein Bereich des Kolbens dann an dem mindestens einen Widerhaken diesen entsprechend weit federnd nach außen biegend vorbei, und danach federt dieser mindestens eine Widerhaken wieder in seine Ruhestellung zurück, in der er dann einen Anschlag für das Kontaktglied bildet, der verhindert, daß der Kolben des Kontaktgliedes aus dem Zylinderglied herausgelangen kann.

Vorzugsweise kann vorgesehen sein, daß der Kolben des Kontaktgliedes eine Ringschulter aufweist, die zur Anlage an den mindestens einen Lappen in der vorderen Ruhestellung des Kontaktgliedes bestimmt ist.

Die im Innenraum des Zylindergliedes angeordneten Federmittel können aus einer oder mehreren Federn bestehen und vorzugsweise vorgespannt sein, so daß in diesem Fall dann das Kontaktglied in seiner unbelasteten, vorderen Ruhestellung an den oder die Lappen angedrückt ist. Es kann jedoch auch vorgesehen sein, daß die Federmittel so kurz sind, daß sie das Kontaktglied nicht an den oder die Widerhaken andrücken.

In der Zeichnung sind Ausführungsbeispiele der Erfindung dargestellt. Es zeigen:

Fig. 1 und 2 Längsschnitte durch je einen Federkontaktstift gemäß Ausführungsbeispielen der Erfin-

Fig. 3    einen vergrößerten Ausschnitt aus Fig. 1,

Fig. 4    den ebenen Zuschnitt des Zylindergliedes des Federkontaktstiftes nach Fig. 1,

Fig. 5 und 6    zwei weitere ebene Zuschnitte für ein Rohr eines Zylindergliedes gemäß Ausführungsbeispielen der Erfindung,

Fig. 7 und 8    je eine schaubildliche ausschnittsweise Ansicht eines aus dem Zuschnitt nach Fig. 5 bzw. 6 hergestellten Rohres,

Fig. 9 und 10    gebrochene Teilschnitte durch die Figuren 7 und 8, gesehen entlang den Schnittlinien 9-9 bzw. 10-10,

Fig. 11    ein gestanztes Blechstück in Draufsicht, welches den gestanzten Zuschnitt für ein zu biegendes Rohr aufweist,

Fig. 12    das aus dem Zuschnitt nach Fig. 11 durch Biegen hergestellte Rohr in teilweise geschnittener Seitenansicht.

Die in Fig. 1 und 2 dargestellten Federkontaktstifte 10 bestehen jeweils aus einem Zylinderglied 11, einer Schraubendruckfeder 13 und einem Kontaktglied 12.

Das gerade Zylinderglied 11 weist sowohl in Fig. 1 als auch in Fig. 2 jeweils ein einstückiges Rohr 9 auf, das im wesentlichen kreiszylindrischen Umfang hat, wobei jedoch an der Umfangswandung jedes dieser Rohre 9 durch Stanzen und Biegen ein federnd biegsamer Widerhaken 14 angeformt ist, der in den Innenraum des Zylindergliedes 11 in von dessen vorderem Ende 16 wegführender Richtung schräg hineinragt und eine schmale, rechteckförmige, federnde Zunge bildet, die einstückig mit dem Rohr 9 ist und sich in axialer Richtung des Rohres 9 jedoch schräg einwärts gebogen erstreckt. Nahe dem hinteren Ende des in Fig. 1 dargestellten, aus dem Rohr 9 bestehenden Zylindergliedes 11 ist eine ringförmige, sich um seinen Umfang erstreckende Innenringschulter 19 vorhanden, an der sich das rückwärtige Ende der vorgespannten Schraubendruckfeder 13 abstützt. Deren vorderes Ende ist auf dem konischen, rückwärtigen Ende des Kolbens 20 des Kontaktgliedes 12 zentriert und drückt diesen Kolben 20 mit seiner vorderen Ringschulter 21 an den für ihn einen Anschlag bildenden Widerhaken 14 an. Das vorzugsweise einstückige Kontaktglied 12 weist anschließend an den Kolben 20 einen zu ihm koaxialen, dünneren Schaft 24 auf, dessen Durchmesser also, wie dargestellt, kleiner als der des Kolbens 20 ist und auf dem ein im Durchmesser vergrößerter Kontaktkopf 26 mit einer Kontaktspitze 27 angeordnet ist.

Der Widerhaken 14 ist in Fig. 3 vergrößert dargestellt.

Alle Teile der Federkontaktstifte 10 nach Fig. 1 und 2 bestehen aus elektrisch gut leitfähigem Metall. Die Kontaktspitze 27 dient dem Kontaktieren von Prüflingen, wie Leiterplatten oder dergl., um zu diesen eine elektrische Verbindung von einem Auswerter oder dergl. einer Prüfvorrichtung zu der betreffenden Stelle des jeweiligen Prüflings herzustellen.

Bei jeder einzelnen Prüfung wird das Kontaktglied 12 durch den Prüfling unter Zusammendrükken der Feder 13 weiter in das Rohr 9 zurückbewegt, beispielsweise bis in die in Fig. 1 strichpunktiert angedeutete Stellung 36 und nach Beendigung der Prüfung des betreffenden Prüflings wird er wieder entfernt, und das Kontaktglied 12 kehrt unter Vorwärtsbewegen in die dargestellte Ausgangsstellung zurück, in der es mit der vorderen Ringschulter 21 des Kolbens 20 wieder an der unteren Querkante 15 des als Anschlag dienenden Widerhakens 14 anliegt.

Das Rohr 9 ist aus einem gestanzten Blechstück hergestellt. Dies ist bei den erforderlichen kleinen Außendurchmessern des Rohres kostengünstig und hat u. a. auch den Vorteil, den Widerhaken 14 besonders einfach mit durch das Stanzen und Biegen des Blechstückes herstellen zu können.

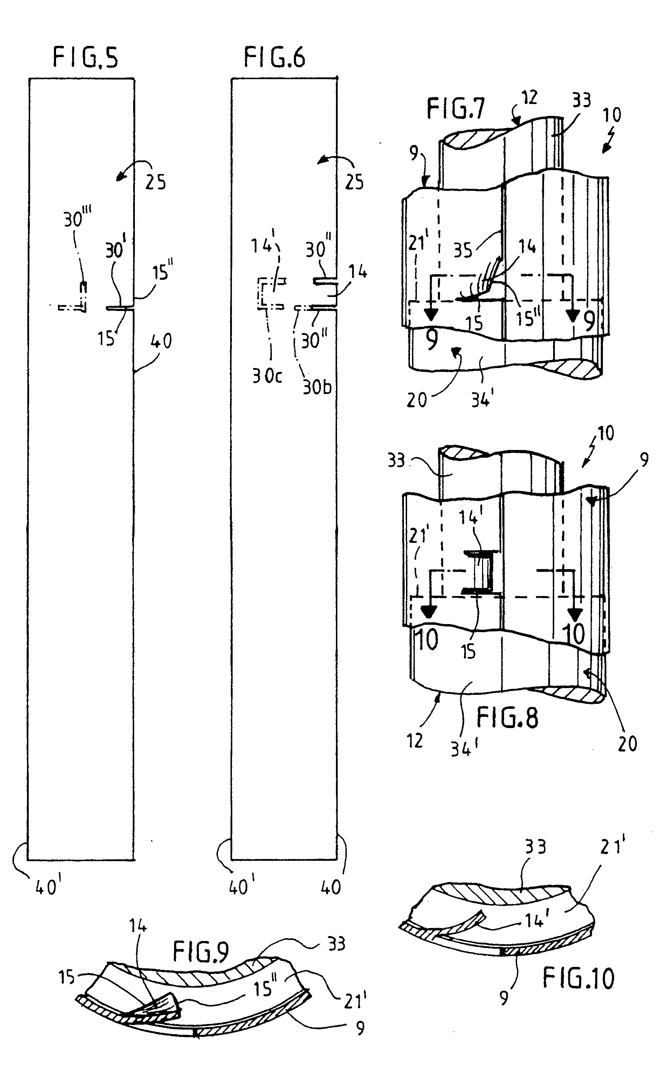

Der Zuschnitt 25 eines solchen, noch ebenen Blechstückes ist in Fig. 4 für das Zylinderglied 11 nach Fig. 1 als Ausführungsbeispiel dargestellt. In diesen rechteckförmigen, ebenen Zuschnitt 25 ist an einer seiner beiden Längsseiten eine L-förmige Ausstanzung 30 vorgenommen, die den zungenförmigen Widerhaken 14 bildet. Dieses Blechstück 25 kann aus weichem, halbhartem, hart gewalztem oder sonstigem Blech bestehen, beispielsweise auch aus federnd elastischem Metall, beispielsweise aus Phosphorbronze, oder aus sonstigem mehr oder weniger elastischem oder unelastischem Metall, dem erforderlichenfalls nach dem Biegen zu dem Rohr 9 zumindest im Bereich des Widerhakens federelastische Eigenschaften durch geeignete Behandlung gegeben werden kann, bspw. kann das Blechstück aus Nickel-Beryllium, Kupfer-Beryllium, Stahl oder dergleichen bestehen. Es kann auch aus anderen geeigneten Metallen bestehen, bspw. aus Messing oder Neusilber. Die den Widerhaken 14 bildende Zunge ist in die in Fig. 1 dargestellte Schrägstellung gebogen. Dieser Zuschnitt 25 wird dann um eine zu seinen beiden langen Seiten 31 parallele geometrische Achse zu dem Rohr 9 gerollt, bei dem die beiden langen Seiten 31 des Zuschnittes 25 aneinanderstoßen oder nur geringen Abstand voneinander haben.

Sofern der Blechzuschnitt schon federnd elastisch war, kann das Rohr, falls gewünscht oder notwendig, an der Stoßfuge bspw. durch Kleben, Löten, Schweißen oder dergl. zusammengehalten sein. Besonders günstig ist es, es aus noch unelastischem Metall zu biegen und ihm dann erst federelastische Eigenschaften zumindest im Bereich des Widerhakens 14 zu geben. Bspw. kann hierzu Kupfer-Beryllium oder Nickel-Beryllium einer thermischen Nachbehandlung unterzogen werden, das Rohr bspw. im Vakuum längere Zeit auf ca. 300 °C gehalten werden. Auch in diesem Fall kann das Rohr 9, falls gewünscht oder zweckmäßig, an der Stoßfuge durch Kleben, Löten, Schweißen oder dergl. zusammengehalten sein.

In den Rohrinnenraum ist der Widerhaken 14, wie dargestellt, hineingebogen, desgl. die Innenringschulter 19 spanlos eingeformt, bspw. durch Rollen oder Drücken.

Die Montage des Federkontaktstiftes 10 nach Fig. 1 ist in der Weise erfolgt, daß zuerst in das wie beschrieben hergestellte Zylinderglied 11 die Schraubenfeder 13 vom vorderen Ende 16 her eingesetzt wird, wobei der Widerhaken 14 erforderlichenfalls zurückgebogen wird, und es wird dann das Kontaktglied 12 mit seinem Kolben 20 in das Zylinderglied 11 eingeschoben, wobei dieser Kolben 20 den Widerhaken 14 federnd entsprechend nach außen biegt. Sobald der Kolben 20 den Widerhaken 14 passiert hat, federt dieser in die dargestellte, schräg nach innen zum Kolben 20 weisende Richtung zurück, in der er nunmehr den die vordere Ruhestellung des Zylindergliedes 11 bestimmenden Anschlag für den Kolben 20 und damit für das Kontaktglied 12 bildet. Der Zusammenbau der drei Teile dieses Federkontaktstiftes 10 ist also äußerst rasch und einfach, auch vollautomatisch durchzuführen. Entsprechendes gilt für den Federkontaktstift nach Fig. 2. Es entfällt also das nachträgliche Anformen eines Anschlages für den Kolben. Anstelle des einen Widerhakens können ggfs. auch mehrere Widerhaken vorgesehen sein.

Das einstückige Kontaktglied 12 des Federkontaktstiftes 10 nach Fig. 1 ist mit der einzigen kreiszylindrischen Umfangsfläche 37 des Kolbens 20 im Zylinderglied mit Gleitlagerspiel axial beweglich gelagert. Das Ausführungsbeispiel nach Fig. 2 unterscheidet sich von dem nach Fig. 1 u.a. darin, daß zur noch besseren Führung des Kontaktgliedes 12 im Rohr 9 des Zylindergliedes 11 der Kolben 20 zwei im axialen Abstand voneinander angeordnete kreiszylindrische Umfangsflächen 32, 32' aufweist, die mit Gleitlagerspiel im Rohr 9 geführt sind und zwischen denen sich ein im Durchmesser erheblich kleinerer zylindrischer Längsbereich 33 des Kolbens 20 dieses vorzugsweise einstückigen Kontaktgliedes 12 befindet. Der zungenförmige Widerhaken 14 ragt in den hierdurch zwischen die

beiden Gleitflächen 32, 32' bildenden Abschnitten 34, 34' des Kolbens 20 bestehenden lichten Raum 44 des Kolbens 20 hinein. In der dargestellten vorderen Ruhestellung des Kontaktgliedes 12 liegt die Ringschulter 21' des Kolbens 20 an der freien, unteren, geraden Querkante 15 des ferner die beiden zueinander parallelen Längskanten 15' aufweisenden Widerhakens 14 an. Dieser Widerhaken weist also insgesamt drei gerade aneinander jeweils rechtwinklig angrenzende Kanten 15, 15' auf. Der Hub des Kontaktgliedes 12 bei der Prüfung von Prüflingen kann zweckmäßig nur so groß sein, daß es nicht zum Auflaufen der vorderen Gleitfläche 32 des Kolbens 20 auf den Widerhaken 14 kommt.

In dem Ausführungsbeispiel nach Fig. 1 besteht das Zylinderglied 11 nur aus einem runden Rohr 9, das auch den Widerhaken 14 und die Innenringschulter 19 bildet und ein einstückiges Teil ist. An das rückwärtige Ende des Zylindergliedes ist ein elektrischer Anschlußdraht 39 als weiterführender elektrischer Leiter angeschlossen.

In dem Ausführungsbeispiel nach Fig. 2 ist in das rückwärtige Ende des nur mit Ausnahme seines Lappens 14 kreiszylindrischen Rohres 9 ein elektrischer Anschlußkontaktstift 39' fest eingesetzt, der auch das Widerlager für die Feder 13 bildet, so daß in diesem Ausführungsbeispiel das Zylinderglied 11 aus dem einstückigen, auch den Widerhaken 14 bildenden Rohr 9 und dem in es fest eingesetzten Anschlußkontaktstift 39' besteht.

Ein wichtiger Vorteil des Widerhakens 14 ist auch, daß der Federkontaktstift 10 problemlos und ohne bleibende Verformung des Zylindergliedes 11 wieder auseinandergenommen werden kann, bspw. zum Auswechseln der Feder 13 und/oder des Kontaktgliedes 12. Hierzu ist es lediglich erforderlich, den Widerhaken 14 mittels eines Werkzeuges, bspw. eines Stiftes oder bei Fig. 2 mittels eines von außen an ihn angesetzten Hakens soweit federnd zurückzubiegen, daß der Kolben 20 freigegeben und das Kontaktglied 12 und gewünschtenfalls auch die Feder 13 aus dem Zylinderglied 11 herausgenommen werden kann. Um den Widerhaken 14 mit einem Haken nach außen ziehen zu können, genügt es, die den Widerhaken 14 bildende Ausstanzung 30 unterhalb oder seitlich des Widerhakens 14 so groß vorzusehen, daß man durch sie hindurch den Widerhaken 14 mittels des Hakens völlig aus dem Innenraum des Rohres 9 herausziehen kann. Die Ausstanzung 30 im Zuschnitt 25 nach Fig. 4 ist hierzu ausreichend groß.

Oft kann auch zweckmäßig vorgesehen sein, daß der Widerhaken 14 oder mindestens ein Widerhaken zur Verbesserung der elektrischen Leitfähigkeit des Federkontaktstiftes an den Schaft 24 bzw. den Längsbereich 33 des Kontaktgliedes 12 federnd angedrückt ist, wie es in Fig. 3 an einem Beispiel strichpunktiert mit eingezeichnet ist. Hierdurch wird die elektrische Leitfähigkeit des Federkontaktstiftes weiter verbessert. Selbstverständlich darf die Anlagekraft des Widerhakens 14' an den Schaft 24 dabei nur so groß sein, daß das Kontaktglied 12 weiterhin seine axialen Hubbewegungen ausführen kann.

In Fig. 2 ist der freie Endbereich des Schaftes 24 als Kontaktspitze 27' ausgebildet.

Obwohl es besonders günstig ist, wenn in der vorderen Stellung des Kontaktgliedes 12 der Kolben 20 am Widerhaken anliegt, kann gegebenenfalls auch vorgesehen sein, daß er in dieser vorderen Stellung an einer anderen Stelle des Kontaktgliedes, vorzugsweise an einem Absatz des Schaftes 24 anliegt.

Wie in Fig. 4 strichpunktiert eingezeichnet ist, kann man auch mehr als nur einen Lappen oder Widerhaken 14 vorsehen. Zu diesem Zweck ist hier eine zusätzliche U-förmige Ausstanzung 30a in Höhe der L-förmigen Ausstanzung 30 im Zuschnitt 25 vorgesehen, die ebenfalls eine Zunge 14 bildet, die am gerollten Rohr 9 der anderen Zunge 14 etwa diametral gegenüberliegt und einwärts gebogen ist, so daß der Kolben 20 durch zwei zueinander ungefähr symmetrische Anschläge 14 in seiner vorderen Grenzstellung gehalten ist. An der raschen Montage dieses Federkontaktstiftes 10 ändert sich nichts.

Die Stoßfuge des Rohres 9 verläuft wegen des rechteckförmigen Zuschnitts 25 axial. Es ist in manchen Fällen auch denkbar, einen parallelogrammförmigen Zuschnitt, der nicht rechteckförmig ist, zu dem Rohr zu biegen, so daß die Stoßfuge schraubenlinienförmigen Verlauf hat. Auch können die Längsränder des Zuschnittes gewünschtenfalls Verzahnungen aufweisen, so daß die Stoßfuge dann wellenförmigen Verlauf hat, usw.

Die L-förmige Ausstanzung 30 in dem Zuschnitt 25 nach Fig. 4 kann das Biegen des Zuschnittes 25 zu dem Rohr 9 wegen der Asymmetrie oft erschweren oder verteuern, und zwar im Hinblick auf die sehr geringen Wandstärken des im wesentlichen kreiszylindrischen Rohres 9, also die sehr geringe Dicke des Blechzuschnittes 25 von beispielsweise 0,08 bis 0,2 mm. In manchen Fällen kann die Blechdicke auch noch etwas kleiner oder größer sein. Dabei ist der rechteckförmige Zuschnitt, der das Rohr 9 nach dem Biegen bildet, verhältnismäßig lang, bspw. 1 bis 10 cm, vorzugsweise 2 bis 6 cm.

Gemäß bevorzugten Ausführungsformen läßt sich das durch Rollen oder auf sonstige Weise erfolgende Biegen des Zuschnittes 25 zum vorzugsweise runden Querschnitt aufweisenden Rohr dadurch erleichtern und mit besonders kostengünstigen Werkzeugen unproblematisch durchführen, indem statt der L-förmigen Ausstanzung 30 eine

einzige gerade Ausstanzung 30' (Fig. 5,7,9) oder zwei gerade und zueinander parallele Ausstanzungen 30" (Fig. 6,8,10) in den rechteckförmigen Zuschnitt 25 anstelle der L-förmigen Ausstanzung 30 der Fig. 4 eingestanzt sind, welche Ausstanzungen schmale Schlitze des Zuschnittes 25 bilden, die rechtwinklig zur betreffenden langen geraden Seite 40 des betreffenden Zuschnittes verlaufen. Der bzw. die Einschnitte 30' bzw. 30" beginnen an dieser langen Seite 40 offen und reichen kurze Strecken in den Zuschnitt 25 hinein. Anstatt dieser geraden Einschnitte 30',30" können sie in manchen Fällen auch nicht gerade, bspw. schwach gewölbt und/oder schräg zur Seite 40 sein.

Die beiden Einschnitte 30" sind in diesem Fall gleich lang, doch kann in manchen Fällen auch vorgesehen sein, daß sie ungleich lang sind, wie für den unteren Einschnitt 30" durch die strichpunktiert dargestellte Verlängerung 30b angedeutet ist.

Es ist besonders vorteilhaft, wenn der oder die Einschnitte 30' bzw. 30" am betreffenden Längsrand 40 des Zuschnittes offen beginnen. Nach dem Biegen des Zuschnitts 25 der Fig. 5 bzw. 6 zu dem betreffenden Rohr 9, bei dem es sich hier um ein dem Rohr 9 der Fig.2 in etwa entsprechendes Rohr handeln kann - jedoch können die Einschnitte 30', 30" auch höher angeordnet werden, wie es bspw. für die L-förmige Ausstanzung der Fig. 4 und damit etwa für das Rohr 9 nach Fig. 1 gilt - wird unter Ausnutzung des Einschnittes 30' (Fig. 5) bzw. der Einschnitte 30" (Fig. 6) je ein zungenförmiger Lappen 14 bzw. 14' in das Rohrinnere gebogen. Vorzugsweise kann der Zuschnitt 25 noch weiches, plastisch biegsames Blech sein, das erst nach dem Biegen zum Rohr und der Lappen 14, 14' durch Wärmebehandlung oder sonstige Vergütung federelastische Eigenschaften erhält. Insbesondere bei dem aus dem Zuschnitt 25 der Fig. 6 gebildeten Rohr 9 (Fig. 8,10) kann auch vorgesehen sein, ihm keine federelastischen Eigenschaften zu geben, sondern nur geringe Elastizität oder gar keine Elastizität.

Der Einschnitt 30' des Zuschnittes 25 nach Fig. 5 dient dazu, einen ungefähr dreieckförmigen Lappen 14 zu biegen, der entweder schon vor dem Biegen des Zuschnittes zu dem Rohr gebogen oder gleichzeitig mit dem Biegen oder nach dem Biegen des Zuschnittes 25 zu dem betreffenden Rohr 9 (Fig. 7,9) so gebogen wird, daß er unter wendelartiger Verschränkung schräg einwärts in das Rohr 9 hineinragt. Dieser ungefähr dreieckförmige,gewölbte Lappen 14 bildet einen ebenfalls zungenförmigen federelastischen Widerhaken, der insgesamt zwei im Zuschnitt 25 noch rechtwinklig zueinander verlaufende Kanten 15,15" aufweist, von denen die Kante 15 als Anschlag für den Kolbenabschnitt 34' eines Kolbengliedes 12 dient, wie es im Ausführungsbeispiel nach Fig. 2 dargestellt ist. Der im Durchmesser verringerte, schaftförmige Zwischenabschnitt 33 des aus diesem Zwischenabschnitt und zwei Kolbenabschnitten 34, 34' (der Kolbenabschnitt 34 ist in Fig. 7 bis 10 nicht dargestellt) bestehenden Kolbens 20 wird in seiner durch die nicht dargestellte Feder des Federkontaktstiftes bewirkten obersten Stellung an die untere Querkante 15 des federnden Widerhakens 14 mit der Ringschulter 21 angedrückt. Dieser Widerhaken 14 der Fig. 7,9 ermöglicht das Zusammensetzen des betreffenden Federkontaktstiftes 10 in gleicher Weise wie bei den Ausführungsbeispielen nach den Figuren 1 und 2, indem in das Rohr 9 zuerst die nicht dargestellte Feder eingesetzt und dann das Kolbenglied 12 mit seinem Kolben voraus in das Rohr 9 eingeschoben wird, wobei der federnd elastische Widerhaken 14 durch den Kolbenabschnitt 34' nach außen gebogen wird und, sobald die Ringschulter 21'dieses Kolbenabschnittes 34' am Widerhaken 14 vorbeigelangt ist, der Widerhaken 14 in die in den Figuren 7 und 9 dargestellte, verschränkt einwärts gebogene Stellung zurückfedert und seine untere Querkante 15 nunmehr den Anschlag für den Ringbund 21' und damit für die obere Grenzstellung des Kolbengliedes 12 bildet.

Die andere Kante 15" des Widerhakens 14 (Fig. 5, 7 und 9) ist durch einen Abschnitt der Längsseite 40 des ursprünglichen Zuschnittes 25 gebildet, welche Längsseite 40 sich in axialer Richtung des Rohres 9 erstreckt und am Rohr 9 der anderen Längsseite 40' des ursprünglichen Zuschnittes 25 ohne Abstand oder mit geringem Abstand unter Bildung einer Stoßfuge 35 gegenüberliegt.

In manchen Fällen kann auch vorgesehen sein, daß zur Bildung eines solchen ungefähr dreieckförmigen, verschränkten Widerhakens 14 nicht ein einziger gerader Einschnitt 30' vorgesehen ist, sondern innerhalb des Zuschnittes 25 eine L-förmige Ausstanzung 30''' angeordnet ist, wie es in Fig. 5 strichpunktiert mit eingezeichnet ist, doch ist der einzige gerade Einschnitt 30' für das Biegen des Rohres 9 günstiger.

Die voll ausgezogene Ausführungsform nach den Figuren 5, 7 und 9 mit dem dargestellten Einschnitt 30' des Zuschnittes 25 ist bezüglich des Widerhakens 14 ganz besonders vorteilhaft für die genaue, einfache Herstellung des Rohres 9 aus dem betreffenden Zuschnitt 25.

Bei dem voll ausgezogen dargestellten rechteckförmigen Zuschnitt 25 nach Fig. 6 ist hier insbesondere daran gedacht, daß dieser Blechzuschnitt 25 aus einem plastisch leicht biegsamen Werkstoff, wie weichem Kupfer-Beryllium oder dgl. besteht, der nach dem Biegen des Rohres 9 (Fig. 8,10) keiner Behandlung zur Erzielung federelastischer Eigenschaften des durch die Einschnitte 30" gebildeten Lappens 14' und auch keiner Behandlung des übrigen Rohres 9 unterzogen wird. Zur Montage wird nach dem Biegen des Rohres 9 der Lappen 14' zunächst noch nicht einwärts in das Rohr 9 hineingebogen, sondern es werden zuerst die nicht dargestellte Feder und das Kolbenglied 12 in das das betreffende Zylinderglied des zusammenzubauenden Federkontaktstiftes 10 bildende oder im wesentlichen bildende Rohr 9 eingesetzt und erst dann wird der Lappen 14' nach einwärts gebogen (Fig. 8, 10) und bildet nunmehr den Anschlag für die vordere Grenzstellung des Kolbengliedes 12, indem die Ringschulter 21' des Kolbenabschnittes 34' in dieser Grenzstellung an der unteren Längskante 15 dieses Lappens 14'zur Anlage kommt. Hierdurch wird zwar die Montage durch den erst nach Einsetzen des Kolbens 20 erforderlichen Arbeitsgang des Einwärtsbiegens des Lappens 14' verteuert, jedoch unter anderem immer noch der Vorteil erreicht, daß keine Beschädigungsgefahr und kein Klemmen des Kolbens durch den Lappen 14 verursacht werden kann.

Man kann auch bei zwei Einschnitten, wie 30" - (Fig. 6), Verschränkung des Lappens 14 in einwärtiger Richtung des Rohres 9 vorsehen, vorzugsweise derart, daß der einwärts gebogene Lappen 14 ebenfalls einen federelastischen Widerhaken bildet, der es ermöglicht, das Kolbenglied 12 in das Rohr 9 erst nach völliger Fertigstellung des Rohres 9 einzusetzen, wie es bei den Ausführungsbeispielen nach den Fig. 1 bis 3, 7 und 9 erläutert wurde. In diesem Fall ist es dann allerdings besonders zweckmäßig, die Einschnitte 30" unterschiedlich lang zu machen, zu welchem Zweck der untere Einschnitt 30" gemäß der strichpunktierten Verlängerung 30b länger als der zu ihm parallel obere Einschnitt 30" gemacht sein kann, was das Verschränken des Lappens 14' zu einem Widerhaken erleichtert.

Man kann in vielen Fällen auch bei dem Zuschnitt 25 nach Fig. 6 vorsehen, daß anstelle der oder zusätzlich zu den beiden Einschnitten 30",vorzugsweise in ihrer Höhe,mindestens eine U-förmige Ausstanzung 30c innerhalb des Zuschnittes 25 vorgesehen ist, die ebenfalls einen Lappen 14' bildet, der nach dem Einsetzen des Kolbengliedes 12 in das aus diesem Zuschnitt hergestellte Rohr zur Bildung eines Anschlages für das Kolbenglied 12 einwärts gebogen wird. Im allgemeinen ist es jedoch besonders günstig, den oder die Einschnitte, wie 30' (Fig. 5) bzw. 30" (Fig. 6), jeweils nur an der oder den betreffenden Längsseiten 40 und ggf. 40' des Zuschnittes 25 beginnen zu lassen und keine weiteren Ausstanzungen für Lappen im Zuschnitt 25 vorzusehen, da dies für das Rollen des Zuschnittes 25 zum Rohr 9 ganz besonders vorteilhaft ist.

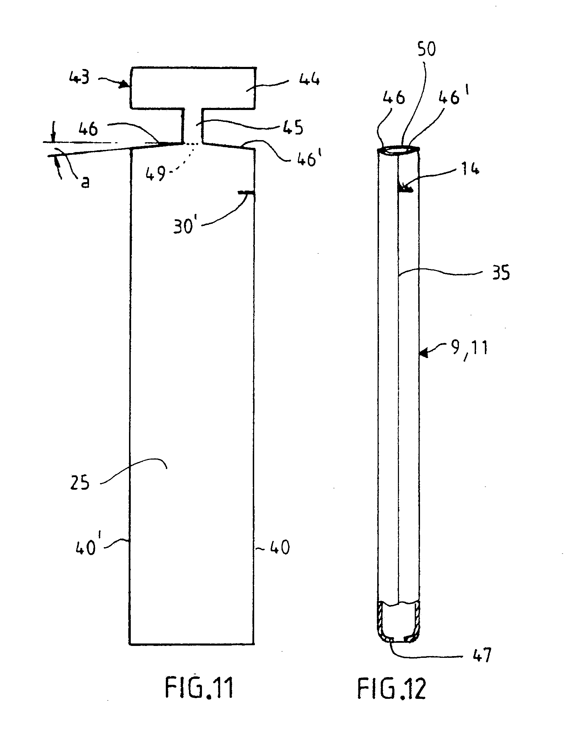

In Fig. 11 ist ein gestanztes ebenes Blechstück 43 in Draufsicht dargestellt, das aus weichem, halbhartem oder hartem Metallblech bestehen kann, das unelastisch oder mehr oder weniger elastisch, oft zweckmäßig federelastisch sein kann, vorzugsweise aus Messing, Neusilber, Nickel-Beryllium oder Kupfer-Beryllium bestehen kann, doch kommen gegebenenfalls auch andere Metalle infrage.

Dieses durch Stanzen aus einer größeren Blechtafel gebildete einstückige Blechstück 43 weist einen Kopf 44 auf, der über einen schmalen Verbindungsstreifen oder Steg 45 mit dem Zuschnitt 25 für ein zu biegendes Rohr 9 (Fig. 12) verbunden ist. Dieser an den Steg 45 anschließende Zuschnitt 25 ist im wesentlichen rechteckförmig, wobei jedoch seine dem Steg 45 benachbarten Seiten 46 und 46' unter einem Winkel a schwach schräg zu einer Linie gerichtet sind, die senkrecht zu den beim fertigen Rohr 9 (Fig. 12) die Stoßfuge 35 bildenden beiden geraden, zueinander parallelen, langen Längsseiten 40, 40' des Zuschnittes 25 verläuft. In die Längsseite 40 ist senkrecht zu ihr ein kurzer gerader Einschnitt 30' in den Zuschnitt 25 eingestanzt, der der Bildung des in den Innenraum des fertigen Rohres 9 hineinragenden federelastischen Lappens oder Widerhakens 14 dient, wie es im Zusammenhang mit dem Ausführungsbeispiel nach den Fig. 5 und 7 bereits beschrieben ist und deshalb keiner weiteren Erläuterung bedarf.

Die Herstellung des Rohres 9 durch Biegen aus dem Zuschnitt 25 nach Fig. 11 kann zweckmäßig so erfolgen, daß dieses Biegen um die Längsachse des herzustellenden Rohres 9 in mehreren aufeinanderfolgenden Biegeschritten an dem Zuschnitt 25 erfolgt, wobei jedoch nur der Zuschnitt 25 selbst gebogen wird, während der Steg 45 und der Kopf 44 des Blechstückes 43 nicht mitgebogen werden. Sobald das Biegen des Rohres 9 zu einem zunächst noch über seine volle Länge mit Ausnahme des in den Rohrinnenraum hineingebogenen Widerhakens 14 kreiszylindrischen Rohr vollendet ist, kann dieses Rohr von dem Steg 45 entlang der gepunktet dargestellten Stanzlinie 49 abgestanzt werden. Man kann dann zweckmäßig zunächst die nicht dargestellten Federmittel, die vorzugsweise aus einer einzigen zylindrischen Schraubenfeder bestehen können, von unten her in das untenseitig noch vollständig offene Rohr 9 einbringen und dann den unteren Endbereich des Rohres zu einem Boden 47 nach innen biegen oder bördeln, wobei dieser Boden 47 nicht vollständig geschlossen zu sein braucht, da er nur so weit durch Biegen herzustellen ist, daß sich die Federmittel dann auf diesem Boden abstützen können. Dieses Rohr 9 bildet hier das Zylinderglied 11 allein. An seinem unteren Ende kann wieder in irgendeiner geeigneten Weise ein Anschlußkontakt oder -leiter angeordnet werden oder erst später beim oder nach dem Einbau in einen Prüfadapter kann der elektrische Anschluß an einen Anschlußkontakt oder weiterführenden Leiter hergestellt werden. Zur Fertigmontage des Federkontaktstiftes mit diesem Rohr 9 ist es dann nur noch erforderlich, das nicht dargestellte Kontaktglied mit seinem Kolben von oben her unter federndem Biegen des Widerhakens 14 in dieses Rohr einzusetzen, so daß der Widerhaken 14, wenn der Kolben an ihm vorbei in den Rohrinnenraum eingeführt ist, dann die Vorwärtsbewegung des Kolbens des Kolbengliedes wie in den anderen Ausführungsbeispielen begrenzt.

Die abgeschrägten Stirnkantenbereiche 46, 46' des Rohres 9 bewirken, daß das sie aufweisende vordere Stirnende 50 des Rohres 9 einen wendelartig ansteigenden Stirnkantenbereich 46 und einen in derselben Umfangsrichtung wie dieser verlaufenden, wendelartig absteigenden Stirnkantenbereich 46' aufweist. Diese beiden Stirnkantenbereiche 46, 46' beginnen bzw. enden an der Stoßfuge 35 und erstrecken sich jeweils jeder über nahezu 180° und sind durch den an den punktierten Linie 49 vorgenommenen, vorzugsweise ebenen Stanzschnitt miteinander verbunden. Diese schrägen Stirnkantenbereiche 46, 46' können im Falle automatisierter oder teilautomatisierter Fertigung des Federkontaktstiftes sowohl zum Erkennen der Winkellage des Rohres 9 wie auch zum Erkennen des den Widerhaken 14 benachbarten vorderen Endes 50 des Rohres dienen, um das Rohr zur Montage des Kontaktgliedes bzw. zum Biegen des Bogens 47 selbsttätig in die richtige Stellung für den jeweils nächsten Fertigungsschrift zu bringen.

Das Rohr 9 kann vorzugsweise folgende Dimensionen haben: Außendurchmesser ca. 0,7 bis 2,5 mm, Länge ca. 10 bis 100 mm, Blechdicke ca. 0,1 bis 0,25 mm. Diese Maße können in manchen Fällen auch noch kleiner oder größer sein.

**Patentansprüche**

1. Federkontaktstift (10) zum Kontaktieren von zu prüfenden elektrischen oder elektronischen Prüflingen, wie Leiterplatten oder dergl., welcher Federkontaktstift elektrisch leitfähig und zur Anordnung an einer Prüfvorrichtung bestimmt ist und ein ein Zylinderglied (11) bildendes, gerades metallisches Rohr (9) aufweist, in dem Federmittel (13) angeordnet sind, die der Federbelastung eines aus dem Rohr (9) herausragenden Kontaktgliedes (12) dienen, dessen vorderes Ende (27; 27') dem Kontaktieren der Prüflinge dient, wobei dieses Kontaktglied (12) einen in dem Rohr (9) mit Gleitlagerspiel axial gleitend gelagerten Kolben (20; 33, 34, 34') aufweist, dadurch gekennzeichnet, daß das Rohr (9) durch ein gestanztes und gebogenes Blechstück (25) gebildet ist und mindestens ein Lappen (14; 14') vorgesehen ist, der aus einem Bereich der Umfangswandung dieses Rohres (9) gebildet ist und in den Rohrinnenraum hineinragt und einen die Vorwärtsbewegung des Kolbens des Kontaktgliedes (12) begrenzenden Anschlag bildet.

2. Federkontaktstift nach Anspruch 1, dadurch gekennzeichnet, daß der mindestens eine Lappen (14; 14') zungenartige Gestalt aufweist.

3. Federkontaktstift nach Anspruch 1 oder 2, dadurch gekennzeichnet, daß der mindestens eine Lappen (14; 14') federelastisch ist.

4. Federkontaktstift nach Anspruch 3, dadurch gekennzeichnet, daß der mindestens eine Lappen einen elastisch federnden, vorzugsweise zungenförmigen, Widerhaken (14) bildet, der so angeordnet ist, daß er das Einsetzen des Kolbens (20) in das Rohr (9) unter durch den Kolben dabei bewirktem federndem Ausbiegen zuläßt.

5. Federkontaktstift nach Anspruch 1 oder 2, dadurch gekennzeichnet, daß der mindestens eine Lappen (14') unelastisch ist.

6. Federkontaktstift nach einem der vorhergehenden Ansprüche, dadurch gekennzeichnet, daß der Kolben (20) des Kontaktgliedes (12) eine Ringschulter (21) aufweist, die zur Anlage an den mindestens einen Lappen (14; 14') in der vorderen Ruhestellung des Kontaktgliedes bestimmt ist und daß der Lappen (14; 14') im Abstand von den Längsenden des Rohres (9) angeordnet ist.

7. Federkontaktstift nach einem der vorhergehenden Ansprüche, dadurch gekennzeichnet, daß das Rohr im wesentlichen kreiszylindrisch ist und daß es einen einzigen Lappen (14; 14') aufweist.

8. Federkontaktstift nach einem der Ansprüche 1 bis 7, dadurch gekennzeichnet, daß der Lappen insgesamt zwei gerade, winklig, vorzugsweise rechtwinklig, zueinander verlaufende, durch Stanzen gebildete Kanten aufweist, von denen die eine in axialer Richtung des Rohres verläuft.

9. Federkontaktstift nach einem der Ansprüche 1 bis 7, dadurch gekennzeichnet, daß der Lappen insgesamt drei gerade, winklig, vorzugsweise jeweils rechtwinklig, aneinander angrenzende Kanten aufweist, und daß vorzugsweise eine Kante des Lappens in axialer Richtung des Rohres verläuft und die beiden anderen Kanten in Umfangsrichtung des Rohres verlaufen.

10. Federkontaktstift nach Anspruch 9, dadurch gekennzeichnet, daß zwei Kanten des Lappens in axialer Richtung des Rohres und die dritte Kante in Umfangsrichtung des Rohres verläuft.

11. Federkontaktstift nach einem der vorhergehenden Ansprüche, dadurch gekennzeichnet, daß das Kontaktglied einen sich an den Kolben (20) anschließenden, dünneren Schaft (24) aufweist, der eine Kontaktspitze (27') bildet oder an dem ein Kontaktkopf (26) angeordnet ist, und daß der mindestens eine Lappen zur Hubbegrenzung seitlich neben dem Schaft angeordnet ist, oder daß der Kolben (20) zwei durch einen im Durchmesser verringerten Längsbereich (33) miteinander verbundene Kolbenabschnitte (34, 34') aufweist und der mindestens eine Lappen (14) in den zwischen diesen beiden Kolbenabschnitten bestehenden lichten Raum (44) hineinragt, wobei vorzugsweise der Lappen (14) oder mindestens ein Lappen zur Verbesserung der elektrischen Leitfähigkeit des Federkontaktstiftes an den Schaft (24) oder an den die beiden Kolbenabschnitte (34, 34') miteinander verbindenden Längsbereich (33) des Kontaktgliedes (12) federnd angedrückt ist.

12. Federkontaktstift nach einem der vorhergehenden Ansprüche, dadurch gekennzeichnet, daß die Stoßfuge (35) des Rohres (9) parallel zu dessen Längsachse verläuft.

13. Federkontaktstift nach einem der vorhergehenden Ansprüche, dadurch gekennzeichnet, daß das Kolbenglied (12) in der durch den mindestens einen Lappen (14; 14') begrenzten Stellung an einer Kante (15) des betreffenden Lappens (14; 14') anliegt.

14. Federkontaktstift nach einem der vorhergehenden Ansprüche, dadurch gekennzeichnet, daß eine Kante (15'; 15'') des mindestens einen gebogenen Lappens (14; 14') ein Bereich einer Längsseite (40) des das Rohr (9) bildenden Blechstückes (25) ist.

15. Federkontaktstift nach einem der vorhergehenden Ansprüche, dadurch gekennzeichnet, daß das rückwärtige Ende des Rohres (9) so nach einwärts gebogen ist, daß es einen Boden (47) des Rohres (9) bildet, der vorzugsweise als Auflager für die Federmittel (13) dient und daß die der Federbelastung des Kontaktgliedes (12) dienenden Federmittel aus einer einzigen Feder (13) bestehen.

16. Federkontaktstift nach einem der vorhergehenden Ansprüche, dadurch gekennzeichnet, daß ein Stirnende des Rohres (9), vorzugsweise sein vorderes Stirnende (15), einen ansteigenden Stirnkantenbereich (46) und einen in derselben Umfangsrichtung wie der ansteigende Stirnkantenbereich (46) verlaufenden absteigenden Stirnkantenbereich (46′) aufweist, welche Stirnkantenbereiche sich vorzugsweise über nahezu je 180° erstrecken.

17. Verfahren zur Herstellung eines Federkontaktstiftes nach einem der vorhergehenden Ansprüche, dadurch gekennzeichnet, daß aus einem vorzugsweise weichen Blech ein Zuschnitt für das Rohr gestanzt wird, in den zur Bildung mindestens eines Lappens mindestens ein Einschnitt mit eingestanzt wird, der eine Kante des zu biegenden Lappens bildet, daß dann der Zuschnitt zu dem Rohr und zuvor, gleichzeitig oder danach der Lappen in Richtung des späteren bzw. bereits vorhandenen Rohrinneren gebogen wird.

18. Verfahren nach Anspruch 17, dadurch gekennzeichnet, daß das Rohr zumindest im Bereich des Lappens einer Behandlung unterzogen wird, die diesem Bereich federelastische Eigenschaften gibt.

19. Verfahren nach Anspruch 17 oder 18, dadurch gekennzeichnet,daß der Zuschnitt für das Rohr aus einem Blech aus federelastischem Material gestanzt wird und einen rechteckförmigen oder im wesentlichen rechteckförmigen Umriß aufweist.

**Claims**

1. A spring contact pin (10) for contacting electrical or electronic specimens to be tested, such as printed circuit boards, which spring contact pin is electrically conductive and intended for arrangement on a testing device and has a straight metal tube (9) forming a cylinder element (11), in which tube (9) spring means (13) are arranged which serve to spring-load a contact element (12) projecting from the tube (9), the front end (27; 27′) of which contact element (12) serves to contact the specimens, the said contact element (12) having a piston (20; 33, 34, 34′) mounted in the tube (9) so as to slide axially with slide bearing clearance, characterised in that the tube (9) is formed by a punched and bent sheet metal part (25) and at least one tab (14; 14′) is provided which is formed from a region of the peripheral wall of the said tube (9) and projects into the tube interior and forms a stop limiting the forward movement of the piston of the contact element (12).

2. A spring contact pin according to claim 1, characterised in that at least one tab (14; 14′) is tongue-shaped.

3. A spring contact pin according to claim 1 or 2, characterised in that at least one tab (14; 14′) is resiliently elastic.

4. A spring contact pin according to claim 3, characterised in that at least one tab forms an elastically resilient, preferably tongue-shaped barb (14) which is arranged in such a way that it permits the insertion of the piston (20) into the tube (9) with resilient deflection caused by the piston in the process.

5. A spring contact pin according to claim 1 or 2, characterised in that at least one tab (14′) is inelastic.

6. A spring contact pin according to any one of the preceding claims, characterised in that the piston (20) of the contact element (12) has an annular shoulder (21) which is intended for resting against at least one tab (14; 14′) in the front rest position of the contact element and in that the tab (14; 14′) is arranged at a distance from the axial ends of the tube (9).

7. A spring contact pin according to any one of the preceding claims, characterised in that the tube is substantially circular cylindrical and in that it has a single tab (14; 14′).

8. A spring contact pin according to any one of claims 1 to 7, characterised in that the tab has altogether two straight edges formed by punching and extending at an angle, preferably at right angles to each other, one of which edges extends in the axial direction of the tube.

9. A spring contact pin according to any one of claims 1 to 7, characterised in that the tab has altogether three straight edges adjoining each other at an angle, preferably at right angles in each case, and in that preferably one edge of the tab extends in the axial direction of the tube and the two other edges extend in the circumferental direction of the tube,

10. A Spring contact pin according to claim 9, characterised in that two edges of the tab extend in the axial direction of the tube and the third edge extends in the circumferential direction of the tube.

11. A spring contact pin according to any one of the preceding claims, characterised in that the contact element has a relatively thin shaft (24) adjacent the piston (20), which shaft (24) forms a contact tip (27') or on which a contact head (26) is arranged, and in that at least one tab is arranged laterally next to the shaft in order to limit travel, or in that the piston (20) has two piston portions (34, 34') which are connected to each other by a longitudinal region (33) reduced in diameter and at least one tab (14) projects into the clear space (44) existing between the two said piston portions, the tab (14) or at least one tab preferably being resiliently pressed against the shaft (24) or against the longitudinal region (33) of the contact element (12), the said longitudinal region (33) connecting the two piston portions (34, 34') to each other, in order to improve the electrical conductivity of the spring contact pin.

12. A spring contact pin according to any one of the preceding claims, characterised in that the joint (35) of the tube (9) extends parallel to the longitudinal axis of the latter.

13. A spring contact pin according to any one of the preceding claims, characterised in that the piston element (12) rests against one edge (15) of the relevant tab (14; 14') in the position limited by the at least one tab (14; 14').

14. A spring contact pin according to any one of the preceding claims, characterised in that one edge (15'; 15'') of the at least one bent tab (14; 14') is a region of a longitudinal side (40) of the sheet metal part (25) forming the tube (9).

15. A spring contact pin according to any one of the preceding claims, characterised in that the rear end of the tube (9) is bent inwards in such a way that it forms a floor (47) of the tube (9), which floor (47) preferably serves as a support for the spring means (13) and in that the spring means serving to spring-load the contact element (12) comprise a single spring (13).

16. A spring contact pin according to any one of the preceding claims, characterised in that one end of the tube (9), preferably its front end (15), has an ascending end edge region (46) and a descending end edge region (46') extending in the same circumferential direction as the ascending end edge region (46), which end edge regions each preferably extend over approximately 180°.

17. A method of manufacturing a spring contact pin according to any one of the preceding claims, characterised in that a blank for the tube is punched from a preferably soft metal sheet, into which blank at least one notch is also punched to form at least one tab, which notch forms one edge of the tab to be bent, in that the blank is then bent to form the tube and, beforehand, simultaneously or subsequently, the tab is bent in the direction of the later or already existing tube interior.

18. A method according to claim 17, characterised in that the tube, at least in the region of the tab, is subjected to a treatment which gives resiliently elastic properties to the said region.

19. A method according to claim 17 or 18, characterised in that the blank for the tube is punched from a metal sheet made of resiliently elastic material and has a rectangular or substantially rectangular contour.

**Revendications**

1. Pointe de contact à ressort (10) pour la mise en contact de pièces électriques ou électroniques à essayer, comme des plaques conductrices ou des pièces similaires, cette pointe de contact à ressort étant électriquement conductrice, conçue pour l'installation sur un dispositif de test, et comportant une pièce mon-cylindrique (11) constituée par un tube métallique rectiligne (9) dans lequel est placé un dispositif de ressorts (13) qui sert de contrainte d'effet de ressort sur un élément de contact (12) faisant saillie en dehors du tube (9), dont l'extrémité antérieure (27 ; 27') sert à la mise en contact avec la pièce à essayer, cet élément de contact (12) comportant un piston (20 ; 33, 34, 34') glissant axialement dans le tube (9) grâce au jeu d'un palier lisse, pointe de contact caractérisée en ce que le tube (9) est constitué d'un morceau de tôle (25) matricé et cintré, et conçu avec au moins une patte (14, 14'), constituée par une partie de la surface extérieure de ce tube (9), qui fait saillie à l'intérieur du tube et constitue une butée qui limite le mouvement vers l'avant du piston de l'élément de contact (12).

2. Pointe de contact à ressort selon la revendication 1, caractérisée en ce qu'au moins l'une des pattes (14, 14') est en forme de languette.

3. Pointe de contact à ressort selon la revendication 1 ou 2, caractérisée en ce qu'au moins l'une des pattes (14, 14') est élastique faisant ressort.

4. Pointe de contact selon la revendication 3, caractérisée en ce qu'au moins l'une des pattes constitue un crochet élastique faisant ressort, de préférence en forme de languette, disposé de telle façon qu'il permet l'introduction du piston (20) dans le tube (9) par flexion du ressort agissant sur le piston.

5. Pointe de contact à ressort selon la revendication 1 ou 2, caractérisée en ce qu'au moins l'une des languettes (14, 14') est non élastique.

6. Pointe de contact à ressort selon l'une des revendications précédentes, caractérisée en ce que le piston (20) de l'élément de contact (12) comporte un épaulement annulaire (21) conçu comme point de contact pour au moins l'une des pattes (14, 14') dans la position de repos antérieure de l'élément de contact et en ce que les pattes (14, 14') sont placées à une certaine distance des extrémités longitudinales du tube (9).

7. Pointe de contact à ressort selon l'une des revendications précédentes, caractérisée en ce que le tube est essentiellement cylindro-circulaire et en ce qu'il comporte une seule patte (14, 14').

8. Pointe de contact à ressort selon l'une des revendications 1 à 7, caractérisée en ce que la patte comporte dans l'ensemble deux arêtes rectilignes, obliques l'une par rapport à l'autre et de préférence perpendiculaires, se rencontrant, réalisées par matriçage, dont l'une est dans la direction axiale du tube.

9. Pointe de contact à ressort selon l'une des revendications 1 à 7, caractérisée en ce que la patte comporte dans l'ensemble trois arêtes rectilignes, obliques les unes par rapport aux autres et de préférence perpendiculaires deux à deux, se rencontrant à leur extrémité, et que, de préférence, l'une de ces arêtes est dans la direction axiale du tube et les deux autres dans la direction périphérique du tube.

10. Pointe de contact à ressort selon la revendication 9, caractérisée en ce que deux des arêtes de la patte sont dans la direction axiale du tube et la troisième dans la direction périphérique du tune.

11. Pointe de contact à ressort selon l'une des revendications précédentes, caractérisée en ce que l'élément de contact comporte une tige mince (24) liée au piston (20), qui constitue une pointe de contact (27') ou sur laquelle est placée une tête de contact (26) et qu'au moins l'une des pattes est disposée latéralement à côté de la tige pour limiter le mouvement de déplacement, ou en ce que le piston (20) comporte deux sections (34, 34') liées entre elles par une partie longitudinale (33) de diamètre réduit et qu'au moins une pattes (14) fait saillie dans l'espace limité (44) constitué entre ces deux sections de piston, ou au moins la patte (14) ou une patte étant appuyée sur la tige (24) ou sur la partie longitudinale (33) reliant ensemble les deux sections de piston (34, 34') de l'élément de contact (12) en vue d'une amélioration de la conductibilité électrique de la pointe de contact à ressort.

12. Pointe de contact à ressort selon l'une des revendications précédentes, caractérisée en ce que la rainure de raccordement (35) du tube (9) est parallèle à son axe longitudinal.

13. Pointe de contact à ressort selon l'une des revendications précédentes, caractérisée en ce que l'élément de piston (12), dans la position limitée par au moins l'une des pattes (14, 14'), est contre une arête (15) de la patte (14, 14').

14. Pointe de contact à ressort selon l'une des revendications précédentes, caractérisée en ce qu'une arête (15, 15') d'au moins une des pattes (14, 14') incurvées est une partie longitudinale (40) du morceau de tôle (25) constituant le tube (9).

15. Pointe de contact à ressort selon l'une des revendications précédentes, caractérisée en ce que l'extrémité postérieure du tube (9) est recourbée vers l'intérieur de telle sorte qu'elle forme une base (47) du tube (9) qui de préférence sert de support pour le dispositif de ressorts (13) et que le dispositif de ressorts servant à la contrainte élastique de l'élément de contact de compose d'un ressort unique (13).

16. Pointe de contact à ressort selon l'une des revendications précédentes, caractérisée en ce qu'une extrémité frontale du tube (9), de préférence son extrémité frontale antérieure (15), comporte un chanfrein frontal montant (46) et un chanfrein frontal descendant (46') dans la direction périphérique du premier, ces chanfreins s'étendent de préférence sur près de 180°.

**17.** Procédé de fabrication d'une pointe de contact à ressort selon l'une des revendications précédentes, caractérisé en ce qu'on matrice dans une tôle de préférence douce, pour la réalisation du tube, une découpe dans laquelle, pour créer au moins une patte, on matrice au moins une entaille qui constitue une arête de la patte à recourber et qu'on cintre la découpe pour en faire un tube avant, en même temps, ou après que l'on cintre la patte dans la direction future ou existante de l'intérieur du tube.

**18.** Procédé selon la revendication 17, caractérisé par la fait que le tube est soumis au moins dans la zone de la patte à un traitement qui donne à cette zone des caractéristiques élastiques avec effet de ressort.

**19.** Procédé selon la revendication 17 ou 18, caractérisé en ce que la découpe par le tube est matricée dans un tôle de matériau élastique avec effet de ressort et qu'elle comporte un contour rectangulaire ou essentiellement rectangulaire.

FIG.1

FIG.2

FIG.3

FIG.4

FIG.5

FIG.6

FIG.7

FIG.8

FIG.9

FIG.10

FIG.11                    FIG.12